(19) **Europäisches Patentamt / European Patent Office / Office européen des brevets**

(11) **EP 1 978 798 A1**

(12) **EUROPEAN PATENT APPLICATION**
published in accordance with Art. 158(3) EPC

(43) Date of publication:
**08.10.2008 Bulletin 2008/41**

(21) Application number: **07707276.7**

(22) Date of filing: **17.01.2007**

(51) Int Cl.:
*H05K 9/00* (2006.01)    *F16J 15/12* (2006.01)

(86) International application number:
**PCT/JP2007/051025**

(87) International publication number:
**WO 2007/083822 (26.07.2007 Gazette 2007/30)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **17.01.2006 JP 2006009207**

(71) Applicants:
• **Seiren Co., Ltd**
  **Fukui-shi, Fukui 918-8003 (JP)**
• **KB Seiren, Ltd.**
  **Sabae-city**
  **Fukui 916-0038 (JP)**

(72) Inventors:
• **TAKEBAYASHI, Kiyotaka**
  **Fukui-shi, Fukui 9188003 (JP)**
• **TAKEGAWA, Toru**
  **Fukui-shi, Fukui 9188003 (JP)**
• **TANAKA, Yutaka**
  **Sabae-shi, Fukui 9160038 (JP)**
• **SHIMIZU, Hiroyasu**
  **Sabae-shi, Fukui 9160038 (JP)**

(74) Representative: **Hamer, Christopher K. et al**
  **Mathys & Squire LLP**
  **120 Holborn**
  **London**
  **EC1N 2SQ (GB)**

(54) **ELECTROCONDUCTIVE GASKET MATERIAL**

(57)    An electrically conductive material for an electrically conductive gasket is to be provided, the electrically conductive material permitting easy manufacture of an electrically conductive gasket in an arbitrary shape, having a cushioning property and making it possible to greatly diminish cutting wastes in punching work and also greatly diminishing the formation of fray and fluff.

According to the present invention there are provided an electrically conductive material comprising a metalized non-woven fabric of a self-bonded continuous organic fiber, as well as an electrically conductive material comprising a metalized, integrally laminated composite sheet of both a non-woven fabric of a self-bonded continuous organic fiber and an organic fiber structure sheet.

EP 1 978 798 A1

**Description**

Field of the Invention

The present invention relates to an electrically conductive gasket material to be used for shielding unnecessary radiant electromagnetic waves generated from the exterior or shielding electromagnetic waves leaking from the interior.

Backgrounds of the Invention

Devices utilizing electronics, i.e., so-called electronic devices, such as personal computers, video games and portable telephones have recently come to be utilized widely and have spread also in general home life. With expansion of use of such electronic devices from industrial use to general use, there frequently occur problems such as malfunctions of other electronic devices caused by electromagnetic waves leaking from the electronic devices in question or radio troubles of communication devices also caused by such leaking electromagnetic waves. These problems have come be taken up as serious problems also in mass communication.

In such a social environment, in fields related to the electronic industry there is an increasing demand for an electromagnetic wave shielding material which exhibits an outstanding effect for preventing various troubles caused by electronic waves leaking from the aforesaid electronic devices.

Generally, the electromagnetic wave generated from a device utilizing electronics and considered to be a matter of particular issue is the electromagnetic wave leaking from a juncture of constituent parts of a device housing or from a gap of an opening/closing door attached to the device housing. Electrically conductive gaskets having various shapes have been proposed for the purpose of shielding such a leaking electromagnetic wave.

Among such electrically conductive gaskets, those having a cushioning property and having an electrical conductivity equal to that of metal have actually been used and proved to be effective to a certain extent as shielding members of a structure which satisfies the purpose of shielding electromagnetic waves. As examples of such products there are

(1) a product (hereinafter referred to as a electrically conductive cloth-wound gasket) comprising a synthetic resin foam of a prismatic shape not plated with metal and a synthetic fiber fabric (hereinafter referred to as an electrically conductive fiber fabric) plated with metal wound round the synthetic resin foam, as shown in U.S. Patent No. 4,857,668,

(2) a metalized, integrally laminated, composite sheet (hereinafter referred to as an electrically conductive foam sheet) comprising an organic fiber structure sheet and a synthetic resin porous sheet, as disclosed in JP 3306665B, and

(3) a metalized non-woven fabric (hereinafter referred to an electrically conductive non-woven fabric) of organic fibers, as disclosed in JP 7-166467A.

Disclosure of the Invention

Objects of the Invention

Among the electrically conductive gaskets referred to above, as to the electrically conductive cloth-wound gasket, a limit is encountered in point of gasket shape. More particularly, the gasket is columnar having a quadrangular or L-shaped section and it is difficult to fabricate a so-called deformed type of gasket such as a doughnut- or petal-shaped gasket. Besides, it is difficult to make fiber fray from a cut face nil. An aluminum foil gasket using aluminum foil instead of an electrically conductive fiber fabric as means for avoiding such fiber fray is available on the market, but since the foil is a metal foil, it becomes hard and repeated compression causes breakage of the aluminum foil. Thus, the use of such an aluminum foil gasket is limited.

The electrically conductive foam sheet is advantageous in that the deformed type gasket can be fabricated easily by mere punching into an arbitrary shape because even the interior synthetic resin porous sheet is metalized. However, there remains the problem that there occurs dropping of metalized organic fiber wastes and porous sheet wastes during punching and the dropped wastes are suspended in the interior of the electronic device concerned, with a consequent fear of damage to the device by electric shorting or of occurrence of a fire.

The electrically conductive non-woven fabric involves the same problems as the above electrically conductive foam sheet; besides, the bonding force between constituent fibers of the non-woven fabric is low and fluff occurs on the material surface in practical use, which also causes the foregoing electric shorting.

As to the parts and materials described in the foregoing three patent literatures, there is a fear of fiber fray, dropping of wastes and fluff, but no problem in practical use has been reported, in such large-sized electrical products as desktop personal computers and plasma displays. However, in mobile electronic devices typified by portable telephones, a large physical load such as a dropping or knocking load is imposed thereon, so that fiber fray or dropping of wastes and fluff are likely to become fatal. For this reason the parts and materials in question are often not adopted.

It is an object of the present invention to solve the above-mentioned problems of the prior art and provide an electrically conductive material easy to manufacture and capable of forming an electromagnetic wave shielding material of high quality.

Summary of the Invention

The construction of the present invention is as follows.

(1) An electrically conductive material comprising a metalized non-woven fabric of a self-bonded continuous organic fiber.

(2) An electrically conductive material as described in (1), wherein the organic fiber is a synthetic fiber.

(3) An electrically conductive material as described in (2), wherein the synthetic fiber is at least one member selected from the group consisting of urethane fiber, polyolefin fiber, nylon fiber and polyester fiber.

(4) An electrically conductive material as described in (1), wherein the non-woven fabric of a self-bonded continuous organic fiber is obtained by a melt-blow method or a spun-bonding method.

(5) An electrically conductive material as described in (1), wherein the metal is at least one metal selected from the group consisting of gold, silver, copper, nickel, tin and cobalt.

(6) An electrically conductive material as described in (1), wherein the metallization is performed by an electroless plating method or an electroplating method.

(7) An electrically conductive material comprising a metalized, integrally laminated composite sheet of both a non-woven fabric of a self-bonded continuous organic fiber and an organic fiber structure sheet.

(8) An electrically conductive material as described in (7) wherein the organic fiber structure sheet is a non-woven, woven or knitted fabric of an organic fiber having a modulus of membrane elasticity of 100 N/in or more.

(9) An electrically conductive material as described in (7) or (8), wherein the organic fiber in the organic fiber structure sheet is a synthetic fiber.

(10) An electrically conductive material as described in (9), wherein the synthetic fiber is at least one fiber selected from the group consisting of urethane fiber, polyolefin fiber, nylon fiber and polyester fiber.

(11) An electrically conductive material as described in (7), wherein the non-woven fabric of a self-bonded continuous organic fiber is obtained by a melt-blow method or a spun-bonding method.

(12) An electrically conductive material as described in (7), wherein the metal is at least one metal selected from the group consisting of gold, silver, copper, nickel, tin and cobalt.

(13) An electrically conductive material as described in (7), wherein the metallization is performed by an electroless plating method of an electroplating method.

(14) An electrically conductive material comprising any of the electrically conductive materials described in (1) to (13) and resin applied thereto.

(15) A electrically conductive gasket part fabricated by punching any of the electrically conductive materials described in (1) to (14).

Brief Description of the Drawings

Fig. 1 is a tensile force - strain curve of an organic fiber structure sheet.

Fig. 2 is a perspective view of an electrically conductive material comprising a metalized non-woven fabric of a self-bonded continuous organic fiber in the present invention.

Fig. 3 is a perspective view of metalized, integrally laminated, composite sheet of both a non-woven fabric of a self-bonded continuous organic fiber and an organic fiber structure sheet in the present invention.

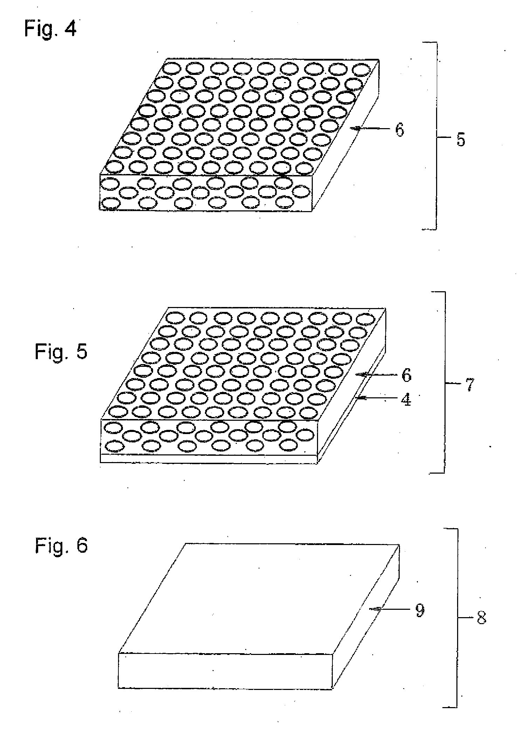

Fig. 4 is a perspective view of an electrically conductive material of a metalized polyurethane foam described in Comparative Example 1.

Fig. 5 is a perspective view of an electrically conductive material comprising a metalized, integrally laminated, composite sheet of both a polyurethane foam and a spun-bonded non-woven fabric of a polyester fiber in Comparative Example 2.

Fig. 6 is a perspective view of an electrically conductive material comprising a metalized spun lace non-woven fabric of a polyester staple fiber in Comparative Example 3.

The following are the contents of reference numerals used in the drawings:

1 ... the whole of an electrically conductive material comprising a metalized non-woven fabric of a self-bonded continuous organic fiber

2 ... a non-woven fabric of a self-bonded continuous organic fiber

3 ... the whole of an electrically conductive material comprising a metalized, integrally laminated composite sheet of both a non-woven fabric of a self-bonded continuous organic sheet and an organic fiber structure sheet

4 ... organic fiber structure sheet

5 ... the whole of an electrically conductive material comprising a metalized polyurethane foam

6 ... polyurethane foam

7 ... the whole of an electrically conductive material comprising a metalized, integrally laminated composite sheet of both a polyurethane foam and an organic fiber structure sheet

8 ... the whole of an electrically conductive material comprising a metalized spun lace non-woven fabric

9 ... spun lace non-woven fabric

Embodiments of the Invention

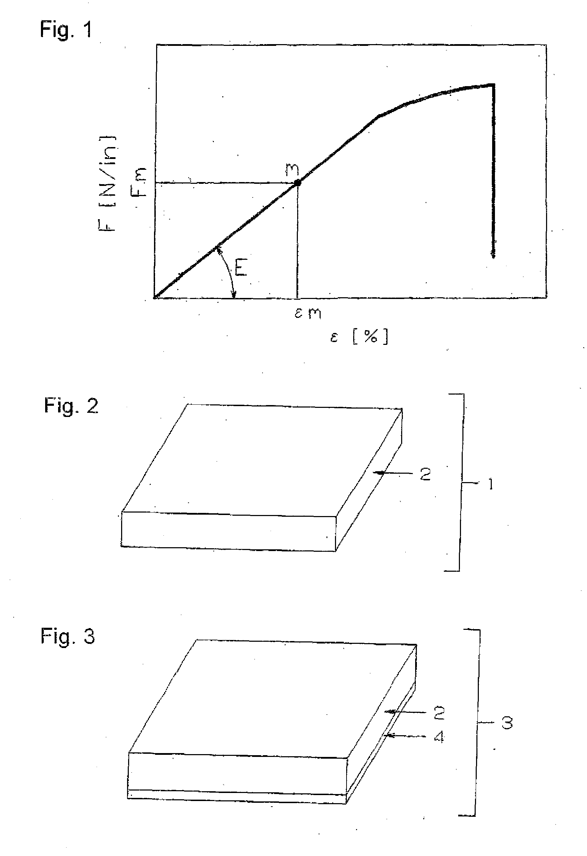

A typical example of the electrically conductive gasket material of the present invention has such a sectional structure as shown in Figs. 2 and 3. In Fig. 2, the reference numeral 1 denotes the whole of an electrically conductive gasket material and numeral 2 denotes a non-woven fabric of a self-bonded continuous fiber, with a metal coating being formed even up to a fiber surface in the interior of the non-woven fabric.

In Fig. 3, numeral 3 denotes the whole of an electrically conductive gasket material, numeral 2 denotes a non-woven fabric of a self-bonded continuous fiber and numeral 4 denotes an organic fiber structure sheet, with a metal coating being formed even up to a fiber surface in the interior of the non-woven fabric 2 and a fiber surface in the interior of the organic fiber structure sheet 4.

The electrically conductive gasket material of the present invention has a structural characteristic such that the fibers which constitute the non-woven fabric (Fig. 2) and the non-woven fabric - organic fiber structure sheet (Fig. 3) before metallization were replaced as they were with metalized fibers. That is, the gasket material in question has air-permeability like that before metallization and the fibers which constitute the non-woven fabric and the organic fiber structure sheet are each covered with an extremely thin metal coating so as not to be influenced by the ambient atmosphere.

By incorporating a flame retardant in the electrically conductive material of the present invention it is possible to realize an electrically conductive material having flame retardancy and suitable as an electromagnetic wave shielding gasket.

The non-woven fabric of a self-bonded continuous fiber used in the present invention is preferably obtained by making at least one thermoplastic resin web-like, the at least one thermoplastic resin being selected from the group consisting of polyurethane, polyolefin (including elastomeric polypropylene and propylene-ethylene copolymer), nylon and polyester (including polyester elastomer). The process for manufacturing of non-woven fabric is not specially limited insofar as it is such a known method as spunbonding method or a melt blown method, with the melt blown method being particularly preferred.

A general melt-blow spinning method will now be described. A thermoplastic resin is extruded through an extruder, then molten polymer is weighed by a gear pump and is discharged from spinning nozzle holes arranged in a row. Heated high-temperature gas is jetted at high speed from slits formed on both sides of the nozzle holes and the polymer extruded from the nozzle holes is thinned and cooled by the high-speed gas flow to form continuous filaments. The thinned filaments are separated from the gas flow on a moving conveyor net collector device substantially without being bunched and are stacked on the net. The stacked filaments are maintained in the stacked state with their own heat and contacts thereof are fusion-bonded. The filaments, after being stacked on the collector device, may be bonded by the application of heat and pressure using rollers or the like before or after cooling and solidifying. In order to strengthen the bonding of filament-to-filament contact points it is preferable that the spacing from the spinning nozzle to the stacked position on the collector device be not so long. The said spacing is preferably 10 to 100 cm, more preferably 20 to 50 cm. A gas flow guide passage may be formed between the nozzle and the collector device, but may be omitted.

In the non-woven fabric of a self-bonded continuous fiber used in the present invention, it is preferable that the filaments be stacked in a disintegrated state substantially without being bunched in their longitudinal direction. If monofilaments are fused in a bunched state without being disintegrated, the non-woven fabric becomes less uniform and its flexibility is greatly impaired.

In the non-woven fabric of a self-bonded continuous fiber used in the present invention, the fiber diameter is preferably 1-50 $\mu$m, more preferably 5-30 $\mu$m, weight is preferably 20-1200 g/m$^2$, elongation is preferably 100% or more, more preferably 300% or more, strength (25 mm width, 1 g/m$^3$) is preferably 6 cN or more, more preferably 10 cN or more, per unit weight, though it differs depending on thickness, and tear strength (25 mm width, 1 g/m$^3$) is preferably 5 cN or more, more preferably 7.5 cN or more, per unit weight. Further, a recovery rate at 100% elongation is preferably 70% or more, more preferably 80% or more. Thus, the non-woven fabric in question is superior in the recovery rate from elongation. Another feature is that the non-woven fabric possesses extremely excellent air-permeability and soft feeling. The air-permeability is preferably 5-200 cc/cm$^2$/s.

Preferably, an organic fiber structure sheet is integrally laminated to the non-woven fabric of a self-bonded continuous fiber in the present invention for the purpose of imparting dimensional stability in plating process to the non-woven fabric. This is for preventing elongation in the advancing direction caused by the imposition of tension on the fabric in the plating process and for preventing eventual difficulty of controlling the thickness to a desired thickness.

As examples of the method for integrally laminating the non-woven fabric of a self-bonded continuous fiber and the organic fiber structure sheet to each other to afford a composite sheet there are mentioned a method wherein an adhesive is applied to the surface of either the non-woven fabric or the organic fiber structure sheet and the other is laminated and bonded to the adhesive and a so-called fusion-bonding method wherein in case of the non-woven fabric of a self-bonded continuous fiber being a heat-melting fabric, at least a part of the surface of the non-woven fabric is heat-melted and immediately thereafter the organic fiber structure sheet is laminated and bonded to the non-woven fabric.

As examples of the organic fiber structure sheet used in the present invention there are mentioned such textile fabrics as woven, knitted and non-woven fabrics formed by using organic fibers.

As examples of organic fibers there are mentioned such chemical fibers as synthetic, semisynthetic and regenerated fibers, as well as such natural fibers as vegetable fibers and animal fibers. Particularly preferred are such synthetic fibers as polyamide fibers, e.g., nylon 6 and nylon 66, and polyester fibers, e.g., polyethylene terephthalate. Above all, polyester fibers such as polyethylene terephthalate fibers are preferred taking productivity, handleability and cost into account.

For example, in the case of polyester fibers, a multifilament yarn with a monofilament size of 0.11-5.6 dtex is preferred. If the monofilament size is smaller than 0.11 dtex, a sufficient strength will not be obtained, while if it is larger than 5.6 dtex, the fabric will become hard and there is a fear that the flexibility of the fabric may be impaired.

As the kind of the textile fabric, non-woven fabric is more preferred. The weight of the textile fabric is preferably 10-100 g/m$^2$.

Taking dimensional stability into account, it is preferable for the organic fiber structure sheet to have a modulus of membrane elasticity of 100 N/in or more.

For forming a metal coating onto the non-woven fabric of a self-bonded continuous organic fiber or the integrally laminated composite sheet there may be adopted a known method such as, for example, sputtering or vacuum deposition. Electroless plating is preferred taking unifying of the metal layer as well as electrical conductivity and shielding property into account. After performing a conventional pre-treatment such as the application of a catalyst or activation for electroless plating, there is performed electroless plating or both electroless plating and subsequent electroplating, using a desired metal such as, for example, gold, silver, copper, nickel, tin, cobalt, copper + nickel, copper + silver, nickel + cobalt, or nickel + copper + nickel.

If metallization is performed by electroless plating or a combination of both electroless plating and electroplating, in comparison with the case where metal foil is laminated to one surface of the non-woven fabric of a self-bonded continuous organic fiber, a metal coating is formed uniformly on the surface portion of each of the fibers present in the interior of the texture of the non-woven fabric and a continuous metal coating is formed also in the thickness direction. This is effective in decreasing the volume resistance value which is important for the electrically conductive gasket material.

The thickness of the metal coating is preferably 0.01-2 μm. If the thickness is smaller than 0.01 μm, a satisfactory shielding property may not be obtained, while if it is larger than 2 μm, not only it is impossible to expect a further improvement of shieldability but also there is a fear that the metal coating may become easier to fall off. In case of using electroless plating or a combination of both electroless plating and electroplating for the formation of a metal coating, it is easy to obtain a desired metal coating thickness and it is possible to form the metal coating without stopping up voids which the non-woven fabric of a self-bonded continuous organic fiber possesses. This is preferable because the cushioning performance of the gasket material is not impaired.

For diminishing peel-off of the metal layer from the non-woven fabric of a self-bonded organic fiber or from the integrally laminated composite sheet it is preferable that the gasket base material be coated with resin after application of the metal layer to the base material and before cutting. The resin to be used is not specially limited for example to a thermoplastic resin, but acrylic resin is preferred taking processability and flexibility into account. As a resin applying method there may be adopted a conventional known method such as, for example, impregnation or coating.

Examples

The present invention will be described below by way of working examples thereof, but the invention is not limited to the following working examples. Non-woven fabrics obtained in the following working and comparative examples were evaluated by the following methods.

MFR of Resin:

Measured in accordance with JIS K 7210 at 230°C and a load of 21.18N.

Average Fiber Diameter of Non-woven Fabric:

Using a scanning electron microscope (SEM), an enlarged (50X) photograph of a non-woven fabric surface was taken, then the diameters of fifty fibers were measured and a mean value thereof was used an average fiber diameter.

Weight of Non-woven Fabric:

Measured in accordance with JIS L1906 "General Filament Non-woven Fabric Testing Method." As the weight, a 100×100 mm test piece was sampled and the weight thereof was measured and converted to a value per m$^2$.

Strength & Elongation of Non-woven Fabric:

Measured in accordance with JIS L1906 "General Filament Non-woven Fabric Testing Method." A test piece having a width of 25 mm and a length of 200 mm was sampled and fixed to a tension tester (manufactured by Orientec) while setting the chuck-to-chuck spacing at 100 mm. The test piece was stretched at a pulling rate of 300 mm/min and strength (25 mm width, 1 g/m$^3$, per unit weight) and elongation were measured at breakage of the test piece.

Air-Permeability of Non-woven Fabric:

Measured in accordance with Frazil Form Method defined in JIS L1906 "General Filament Non-woven Fabric Testing Method." A test piece of about 200×200 mm was sampled and measured for air-permeability with use of an air-permeability tester (a product of TEXTEST).

Elongation Recovery Rate of Non-woven Fabric:

Measured in accordance with JIS L1096 "General Fabric Testing Method." The recovery rate in the evaluation made according to the present invention is a recovery rate at 100% elongation. A test piece having a width of 25 mm and a length of 200 mm was sampled and fixed to a tension tester (manufactured by Orientec) while setting the chuck-to-chuck spacing at 100 mm. The test piece was stretched up to 100% at a pulling rate of 300 mm/min and then the cross head was returned to its original position at the same pulling rate as in stretching to make zero the stress imposed on the non-woven fabric. The test piece was again stretched up to 100% at the same pulling rate as above and a stretched length of the non-woven fabric at a time point of re-starting of stress loading was assumed to be L mm. An elongation recovery rate was determined in accordance with the following equation:

$$\texttt{Elongation Recover Rate (\%) = ((100-L)/100)} \times 100$$

Modulus of Membrane Elasticity:

Measured in accordance with JIS L1906 "General Filament Fiber Non-woven Fabric Testing Method." A test piece having a width of 25 mm and length of 200 mm was sampled and fixed to a tension tester (manufactured by Shimadzu Corp.) while setting the chuck-to-chuck spacing at 100 mm. The test piece was stretched at a pulling rate of 300 mm/min and a modulus of membrane elasticity was calculated from the gradient of S-S curve and in accordance with the following equation:

$$\texttt{E = Fm} \div \texttt{(εm} \div \texttt{100)}$$

E      modulus of membrane elasticity [N/in]

F    tensile force [N/in]

$\varepsilon$    strain [%]

m    a point at which the relation between tensile force F and strain $\varepsilon$ maintains a rectilinear relation

Fm    tensile force at point m

$\varepsilon$m    strain at point m

Thickness:

Measured in accordance with JIS L-1098.

Measuring device ... a constant pressure thickness measuring device TYPE PF-11 (manufactured by TECLOCK Co.)

Stress at 50% Compression:

A sample cut to a size of 10 mm square was put on a pressure bearing board and compressed at a rate of 0.5 mm/sec, then the load corresponding to a sample thickness of 50% of the initial thickness was read and divided by the area of the sample to obtain a pressure at 50% compression.

Surface Resistance:

Both ends of a test piece having a width of 120 mm and a length of 120 mm were sandwiched in between 100 mm wide electrodes and a resistance value across the 100 mm spacing was measured.

Volume Resistance:

A test piece having a width of 120 mm and a length of 120 mm was sandwiched in between copper plates each having a width of 100 mm, a length of 100 mm and a weight of 3 kg and a resistance value between the copper plates was measured.

Cutting Wastes:

The occurrence of wastes when cutting each sample with scissors was checked visually.

| | |
|---|---|
| Very Good: | Cutting wastes occurred little. |
| Good: | Cutting wastes occurred a little. |
| Not Bad: | Cutting wastes occurred. |
| Bad: | Cutting wastes occurred conspicuously. |

Fray & Fluff:

Fray and fluff of fibers when cutting each sample with scissors were checked visually.

| | |
|---|---|
| Good: | There is neither fray nor fluff of fibers. |
| Not Bad: | There are a few fray and fluff of fibers. |
| Bad: | There are fray and fluff of fibers. |

[Example 1]

A propylene-ethylene copolymer (VM2330, a product of Exxon Mobile, MFR: 300) was melt-kneaded in an extruder at 190°C, then weighed by a gear pump and discharged from a melt brown nozzle having 0.5 mm dia, holes arranged in one row at 2 mmpitch. The polymer was extruded at a discharge condition of 0.96 g/min per nozzle hole and was thinned and solidified with heated air (236°C, 9 Nl/cm/min) blown off from both sides of the nozzle to form 20 $\mu$m dia. filaments. The filaments were blown onto a moving conveyor net located at a position of 20 cm from the nozzle and at the same time were sucked in a suction quantity (sucking rate = 6 m/s) three times as large as the heated air by means of a suction device disposed just under the conveyor net, affording a polyolelfin-based elastic fiber non-woven fabric having a weight of 200 g/m$^2$, an elongation of 460%, a strength of 13.8 N and a 100% elongation recovery rate of 82%.

The raw fabric thus obtained was then immersed in a 40°C aqueous solution containing 0.3 g/L of palladium chloride, 30 g/L of stannous chloride and 300 ml/L of 36% hydrochloric acid for 2 minutes and thereafter washed with water. Subsequently, the fabric was immersed in borofluoric acid having an acid concentration of 0.1N at 30°C for 5 minutes and thereafter washed with water. Next, the fabric was immersed in an electroless copper plating solution consisting of 7.5 g/L of copper sulfate, 30 ml/L of 37% formalin and 85 g/L of Rochelle salt at 30°C for 5 minutes and therewafter washed with water. Then, the fabric was immersed in an electroless nickel plating solution consisting of 30 g/L of nickel sulfate, 20 g/L of sodium hypophoshite and 50 g/L of ammonium citrate at 35 °C for 5 minutes, allowing nickel to be laminated to the fabric, followed by washing with water. As shown in Table 1, there was a little dropping of cutting wastes. Particularly, there was no large waste derived from fibers, with only a small amount of formation of metal powder small in particle diameter.

[Example 2]

30% of polypropylene resin (a product of Idemitsu Petrochemical Co., Ltd.) was added to the propylene-ethylene copolymer (VM2330, a product of Exxon Mobile) described in Example 1 and both were melt-kneaded in an extruder at 210°C, followed by the same operations as in Example 1, to prepare non-woven fabric. The non-woven fabric had a fiber diameter of 20 $\mu$m, a weight of 200 g/m$^2$, an elongation of 420%, a strength of 14.7N and a 100% elongation recovery rate of 80%. Spinning conditions were good.

The raw fabric thus obtained was then immersed in a 40°C aqueous solution containing 0.3 g/L of palladium chloride, 30 g/L of stannous chloride and 300 ml/L of 36% hydrochloric acid for 2 minutes and thereafter washed with water. Subsequently, the fabric was immersed in borofluoric acid having an acid concentration of 0.1N at 30°C for 5 minutes and thereafter washed with water. Next, the fabric was immersed in an electroless copper plating solution consisting of 7.5 g/L of copper sulfate, 30 ml/L of 37% formalin and 85 g/L of Rochelle salt at 30°C for 5 minutes and thereafter washed with water. Then, the fabric was immersed in an electroless nickel plating solution consisting of 30 g/L of nickel sulfate, 20 g/L of sodium hypophosphite and 50 g/L of ammonium citrate at 35°C for 5 minutes, allowing nickel to be laminated to the fabric, followed by washing with water. As shown in Table 1, there was a little dropping of cutting wastes. Particularly, there was no large waste derived from fibers, with only a small amount of formation of metal powder small in particle diameter.

[Example 3]

30% of polypropylene resin (a product of Idemitsu Petrochemical Co., Ltd.) was added to the propylene-ethylene copolymer (VM2330, a product of Exxon Mobile) described in Example 1 and both were melt-kneaded in an extruder at 210°C, followed by the same operations as in Example 1, to prepare non-woven fabric. The non-woven fabric had a fiber diameter of 20 $\mu$m, a weight of 200 g/m$^2$, an elongation of 420%, a strength of 14.7N and a 100% elongation recovery rate of 80%. Spinning conditions were good.

Next, the raw fabric thus obtained was bonded to spun-bonded non-woven fabric (weight 40 g/m$^2$, modulus of membrane elasticity 3000 N/in) of polyester filaments (monofilament size: 2.2 dtex) to afford a 0.8 mm thick composite.

The composite thus obtained was then immersed in a 40°C aqueous solution containing 0.3 g/L of palladium chloride, 30 g/L of stannous chloride and 300 ml/L of 36% hydrochloric acid for 2 minutes and thereafter washed with water. Subsequently, the fabric was immersed in borofluoric acid having an acid concentration of 0.1N at 30°C for 5 minutes and thereafter washed with water. Then, the composite was immersed in an electroless copper plating solution consisting of 7.5 g/L of copper sulfate, 30 ml/L of 37% formalin and 85 g/L of Rochelle salt at 30°C for 5 minutes and thereafter washed with water. Subsequently, the composite was immersed in an electroless nickel plating solution consisting of 30 g/L of nickel sulfate, 20 g/L of sodium hypophosphite and 50 g/L of ammonium citrate at 35°C for 5 minutes, allowing nickel to be laminated to the composite, followed by washing with water. As shown in Table 1, there was a little dropping of cutting wastes. Although large wastes derived from spun bonding were formed in a small amount, the amount of metal powder small in particle diameter was small.

[Example 4]

30% of polypropylene resin (a product of Idemitsu Petrochemical Co., Ltd.) was added to the propylene-ethylene copolymer (VM2330, a product Exxon Mobile) described in Example 1 and both were melt-kneaded in an extruder at 210°C, followed by the same operations as in Example 1, to prepare non-woven fabric. The non-woven fabric had a fiber diameter of 20 $\mu$m, a weight of 200 g/m$^2$, an elongation of 420%, a strength of 14.7N and a 100% elongation recovery rate of 80%. Spinning conditions were good.

Next, polyester filaments (monofilament size: 2.8 dtex) having a size of 30 d/12f were woven so as to have a weave density of warp $\times$ weft = 105 pc. $\times$ 75 pc. /in to afford raw fabric of an organic fiber structure sheet having a weight of 23 g/m² and a modulus of membrane elasticity of 1200 N/n.

Then, for the removal of oil and for the impartment of dimensional stability, the raw fabric thus obtained was subjected to scouring and setting and was bonded to the non-woven fabric, affording a 0.9 mm thick composite.

Subsequently, the composite thus obtained was immersed in a 40°C aqueous solution containing 0.3 g/L of palladium chloride, 30 g/L of stannous chloride and 300 ml/L of 36% hydrochloric acid for 2 minutes and thereafter washed with water.

The composite was then immersed in borofluoric acid having an acid concentration of 0.1N at 30°C for 5 minutes and thereafter washed with water. Next, the composite was immered in an electroless copper plating solution consisting of 7.5 g/L of copper sulfate, 30 ml/L of 37% formalin and 85 g/L of Rochelle salt at 30°C for 5 minutes and thereafter washed with water. Thereafter, the composite was immersed in an electroless nickel plating solution consisting of 30 g/L of nickel sulfate, 20 g/L of sodium hypophosphite and 50 g/L f ammonium citrate at 35°C for 5 minutes, allowing nickel to be laminated to the composite, followed by washing with water. As shown in Table 1, there was a little dropping of cutting wastes. Particularly, there was no large waste derived from fibers, with only a small amount of formation of metal power small in particle diameter.

[Example 5]

30% of polypropylene resin (a product of Idemitsu Petrochemical Co., Ltd.) was added to the propylene-ethylene copolymer (VM2330, a product of Exxon Mobile) described in Example 1 and both were melt-kneaded in an extruder at 210°C, followed by the same operations as in Example 1, to prepare non-woven fabric. The non-woven fabric had a fiber diameter of 20 $\mu$m, a weight of 200 g/m², an elongation of 420%, a strength of 14.7N and a 100% elongation recovery rate of 80%. Spinning conditions were good.

Next, the raw fabric thus obtained was bonded to spun-bonded non-woven fabric (weigh 40 g/m², modulus of membrane elasticity 3000 N/in) of polyester filaments (monofilament denier: 2.0 d) to afford a 0.8 mm thick composite.

The composite thus obtained was then immersed in a 40°C aqueous solution containing 0.3 g/L of palladium chloride, 30 g/L of stannous chloride and 300 ml/L of 36% hydrochloric acid for 2 minutes and thereafter washed with water. Subsequently, the composite was immersed in borofluoric acid having an acid concentration of 0.1 N at 30°C for 5 minutes and thereafter washed with water. Next, the composite was immersed in an electroless copper plating solution consisting of 7.5 g/L of copper sulfate, 30 ml/L of 37% formalin and 85 g/L of Rochelle salt at 30°C for 5 minutes and thereafter washed with water. The composite was then immersed in an electroless nickel plating solution consisting of 30 g/L of nickel sulfate, 20 g/L of sodium hypophosphite and 50 g/L of ammonium citrate at 35°C for 5 minutes, allowing nickel to be laminated to the fabric, followed by washing with water.

Then, the composite thus metalized was immersed in 40 g/L of an aqueous acrylic resin (solids content 47%) and thereafter dried.

As shown in Table 1, there was no dropping of cutting wastes, nor was there any large waste derived from fibers, with little formation of metal powder small in particle diameter.

[Example 6]

A polycarbonate-based polyurethane resin (a product of Nippon Polyurethane Co.) was melt-kneaded in an extruder at 230°C, followed by the same operations as in Example 1, to prepare non-woven fabric. The non-woven fabric had a fiber diameter of 20 $\mu$m, a weight of 200 g/m², an elongation of 480%, a strength of 38.3N and a 100 elongation recovery rate of 90%. Spinning conditions were good.

The raw fabric thus obtained was then immersed in a 40°C aqueous solution containing 0.3g/L of palladium chloride, 30 g/L of stannous chloride and 300 ml/L of 36% hydrochloric acid for 2 minutes and thereafter washed with water. Subsequently, the fabric was immersed in borofluoric acid having an acid concentration of 0.1N at 30°C for 5 minutes and thereafter washed with water. Next, the fabric was immersed in an electroless copper plating solution consisting of 7.5 g/L of copper sulfate, 30 ml/L of 37% formalin and 85 g/L of Rochelle salt at 30°C for 5 minutes and thereafter washed with water. The fabric was then immersed in an electroless nicking plating solution consisting of 30 g/L of nickel sulfate, 20 g/L of sodium hypophosphite and 50 g/l of ammonium citrate at 35°C for 5 minutes, allowing nickel to be laminated to the fabric, followed by washing with water. As shown in Table 1, there was a little dropping of cutting wastes. Particularly, there was no large waste derived from fibers, with only a small amount of formation of metal powder small in particle diameter.

[Example 7]

Polyester elastomer resin (P-40B, a product of Toyobo Co., Ltd., MFR: 10 (230°C)) was melt-kneaded in an extruder at 260°C, followed by the same operations as in Example 1, to prepare non-woven fabric. The non-woven fabric had a fiber diameter of 20 $\mu$m, a weight of 200 g/m$^2$, an elongation of 640%, a strength of 22.1N and a 100% elongation recovery rate of 88%. Spinning conditions were good.

The raw fabric thus obtained was then immersed in a 40°C aqueous solution containing 0.3 g/L of palladium chloride, 30 g/L f stannous chloride and 300 ml/L of 36% hydrochloric acid for 2 minutes and thereafter washed with water. Subsequently, the fabric was immersed in borofluoric acid having an acid concentration of 0.1N at 30°C for 5 minutes and thereafter washed with water. Next, the fabric was immersed in an electroless copper plating solution consisting of 7.5 g/L of copper sulfate, 30 ml/L of 37% formalin and 85 g/L of Rochelle salt at 30°C for 5 minutes and thereafter washed with water. The fabric was then immersed in an electroless nickel plating solution consisting of 20 g/L of nickel sulfate, 30 g/L of sodium hypophosphite and 50 g/L of ammonium citrate at 35°C for 5 minutes, allowing nickel to be laminated to the fabric, followed by washing with water. As shown in Table 1, there was no dropping of cutting wastes, nor was there any large waste derived from fibers, with little formation of metal powder small in particle diameter.

[Example 8]

Polyester elastomer resin (P-30B, a product of Toyobo Co., Ltd., MFR: 14 (190°C)) was melt-kneaded in an extruder at 250°C, followed by the same operations as in Example 1, to prepare non-woven fabric. The non-woven fabric had a fiber diameter of 20 $\mu$m, a weight of 75 g/m$^2$, an elongation of 520%, a strength of 9.4N and a 100% elongation recovery rate of 87%. Spinning conditions were good.

The raw fabric thus obtained was immersed in a 40°C aqueous solution containing 0.3 g/L of palladium chloride, 30 g/L of stannous chloride and 300 ml/L of 36% hydrochloric acid for 2 minutes and thereafter washed with water. Subsequently, the fabric was immersed in borofluoric acid having an acid concentration of 0.1N at 30°C for 5 minutes and thereafter washed with water. Next, the fabric was immersed in an electroless nick plating solution consisting of 30 g/L of nickel sulfate, 20 g/L of sodium hypophosphite and 50 g/L of ammonium citrate at 35°C for 5 minutes and thereafter washed with water. The fabric was then immersed in an electroless copper plating solution consisting of 7.5 g/L of copper sulfate, 30 ml/L of 37% formalin and 85 g/L of Rochelle salt, allowing copper to be laminated to the fabric, followed by washing with water. Further, the fabric was immersed in an electroless nickel plating solution consisting of 30 g/L of nickel sulfate, 20 g/L of sodium hypophosphite and 50 g/L of ammonium citrate at 35°C for 5 minutes, allowing nickel to be laminated to the fabric, followed by washing with water. As shown in Table 1, there was no dropping of cutting waste, nor was there any large waste derived from fibers, with little formation of metal powder small in particle diameter.

[Comparative Example 1]

Metal was applied to a polyurethane foam having a thickness of 1.2 mm and a density of 30 pc/in in the same manner as in Example 1 to afford an electromagnetic wave shielding material. As shown in Table 1, dropping of cutting wastes was conspicuous. Particularly, large wastes derived from polyurethane foam were observed and performance was not satisfactory.

[Comparative Example 2]

A polyurethane foam having a thickness of 1.2 mm and a density of 30 pc/in and spun-bonded non-woven fabric (weight 40 g/m$^2$, modulus of membrane elasticity 3000 N/in) of polyester filaments (monofilament denier: 2.0d) were bonded together to afford a 1.3 mm thick composite.

Then, metal was applied to the composite in the same manner as in Example 1 to afford an electromagnetic shielding material. As shown in Table 1, dropping of cutting wastes was conspicuous. Particularly, large wastes derived from the fabric and polyurethane foam were observed and performance was not satisfactory.

[Comparative Example 3]

Metal was applied to spun lace non-woven fabric (weight 50 g/m$^2$) of polyester staple fibers (staple fiber denier: 2.0d) in the same manner as in Example 1 to afford an electromagnetic shielding material. As shown in Table 1, dropping of cutting wastes was conspicuous. Particularly, large wastes derived from polyester staple fibers were observed and performance was not satisfactory.

Table 1

| | Thickness (mm) | 50% Stress (gf/cm$^2$) | Surface Resistance Value (Ω/sq) | Volume Resistance Value (mΩ) | Cutting Wastes | Fray·Fluff |
|---|---|---|---|---|---|---|
| Example 1 | 0.8 | 1958 | 0.03 | 2.9 | Good | Good |
| Example 2 | 0.8 | 2135 | 0.03 | 2.7 | Good | Good |
| Example 3 | 0.9 | 2267 | 0.03 | 2.3 | Good | Good |
| Example 4 | 0.9 | 2738 | 0.03 | 1.1 | Good | Not Bad |
| Example 5 | 0.8 | 2183 | 0.03 | 1.0 | Very Good | Good |
| Example 6 | 1.0 | 573 | 0.03 | 1.0 | Good | Good |
| Example 7 | 1.0 | 1352 | 0.02 | 0.2 | Very Good | Good |
| Example 8 | 0.5 | 1013 | 0.02 | 0.3 | Very Good | Good |
| Comparative Example 1 | 1.2 | 473 | 0.03 | 2.5 | Bad | Good |
| Comparative Example 2 | 1.2 | 497 | 0.03 | 2.5 | Bad | Good |
| Comparative Example 3 | 0.5 | 677 | 0.03 | 2.5 | Bad | Bad |

Industrial Applicability

By using the electrically conductive material of the present invention, in comparison with the electromagnetic wave shielding material so far used in electronic devices, it is possible to easily manufacture an electrically conductive gasket of an arbitrary shape, a satisfactory cushioning property is attained, the amount of cutting wastes in punching work can be decreased to a great extent and so can be the formation of fray and fluff.

**Claims**

1. An electrically conductive material comprising a metalized non-woven fabric of a self-bonded continuous organic fiber.

2. An electrically conductive material as set forth in claim 1, wherein the organic fiber is a synthetic fiber.

3. An electrically conductive material as set forth in claim 2, wherein the synthetic fiber is at least one member selected from the group consisting of urethane fiber, polyolefin fiber, nylon fiber and polyester fiber.

4. An electrically conductive material as set forth in claim 1, wherein the non-woven fabric of a self-bonded continuous organic fiber is obtained by a melt-blow method or a spun-bonding method.

5. An electrically conductive material as set forth in claim 1, wherein the metal is at least one metal selected from the group consisting of gold, silver, copper, nickel, tin and cobalt.

6. An electrically conductive material as set forth in claim 1, wherein the metallization is performed by an electroless plating method or an electroplating method.

7. An electrically conductive material comprising a metalized, integrally laminated composite sheet of both a non-woven fabric of a self-bonded continuous organic fiber and an organic fiber structure sheet.

8. An electrically conductive material as set forth in claim 7, wherein the organic fiber structure sheet is a non-woven, woven or knitted fabric of an organic fiber having a modulus of membrane elasticity of 100 N/in or more.

9. An electrically conductive material as set forth in claim 7 or claim 8, wherein the organic fiber in the organic fiber structure sheet is a synthetic fiber.

10. An electrically conductive material as set forth in claim 9, wherein the synthetic fiber is at least one member selected from the group consisting of urethane fiber, polyolefin fiber, nylon fiber and polyester fiber.

11. An electrically conductive material as set forth in claim 7, wherein the non-woven fabric of a self-bonded continuous organic fiber is obtained by a melt-blow method or a spun-bonding method.

12. An electrically conductive material as set forth in claim 7, wherein the metal is at least one metal selected from the group consisting of gold, silver, copper, nickel, tin and cobalt.

13. An electrically conductive material as set forth in claim 7, wherein the metallization is performed by an electroless plating method or an electroplating method.

14. An electrically conductive material comprising any of the electrically conductive materials described in claims 1 to 13 and resin applied thereto.

15. An electrically conductive gasket part fabricated by punching any of the electrically conductive materials described in claims 1 to 14.

Fig. 1

Fig. 2

Fig. 3

Fig. 4

Fig. 5

Fig. 6

## INTERNATIONAL SEARCH REPORT

| International application No. |
| --- |
| PCT/JP2007/051025 |

A. CLASSIFICATION OF SUBJECT MATTER
*H05K9/00*(2006.01)i, *F16J15/12*(2006.01)i

According to International Patent Classification (IPC) or to both national classification and IPC

B. FIELDS SEARCHED

Minimum documentation searched (classification system followed by classification symbols)
H05K9/00, F16J15/12

Documentation searched other than minimum documentation to the extent that such documents are included in the fields searched
Jitsuyo Shinan Koho          1922-1996      Jitsuyo Shinan Toroku Koho      1996-2007
Kokai Jitsuyo Shinan Koho    1971-2007      Toroku Jitsuyo Shinan Koho      1994-2007

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X | JP 4-97809 A  (Yugen Kaisha Koki Engineering), 30 March, 1992 (30.03.92), Page 1, left column, lines 9 to 12; page 2, lower left column, lines 10 to 18 (Family: none) | 1-3 |
| X | JP 2000-273762 A  (Teijin Ltd.), 03 October, 2000 (03.10.00), Full text (Family: none) | 1-3 |
| A | JP 2003-175565 A  (Seiren Co., Ltd.), 24 June, 2003 (24.06.03), Full text & US 2003/0036326 A1 | 1-3 |

| ☒ | Further documents are listed in the continuation of Box C. | | ☐ | See patent family annex. |
| --- | --- | --- | --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 19 April, 2007 (19.04.07) | 01 May, 2007 (01.05.07) |

| Name and mailing address of the ISA/ | Authorized officer |
| --- | --- |
| Japanese Patent Office | |
| Facsimile No. | Telephone No. |

Form PCT/ISA/210 (second sheet) (April 2005)

**INTERNATIONAL SEARCH REPORT**

International application No.

PCT/JP2007/051025

C (Continuation).   DOCUMENTS CONSIDERED TO BE RELEVANT

| Category* | Citation of document, with indication, where appropriate, of the relevant passages | Relevant to claim No. |
|---|---|---|
| A | WO 98/06247 A1  (Seiren Co., Ltd.),<br>12 February, 1998 (12.02.98),<br>Full text<br>& US 6569789 B1          & EP 0917419 A1 | 1-3 |
| A | JP 2000-167963 A  (Asahi Chemical Industry Co.,<br>Ltd.),<br>20 June, 2000 (20.06.00),<br>Full text<br>(Family: none) | 1-3 |
| A | JP 10-32397 A  (Achilles Corp.),<br>03 February, 1998 (03.02.98),<br>Full text<br>(Family: none) | 1-3 |
| P,A | JP 2006-299447 A  (Seiren Co., Ltd.),<br>02 November, 2006 (02.11.06),<br>Full text<br>(Family: none) | 1-3 |

Form PCT/ISA/210 (continuation of second sheet) (April 2005)

## INTERNATIONAL SEARCH REPORT

| International application No. |
| --- |
| PCT/JP2007/051025 |

**Box No. II**     **Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III**     **Observations where unity of invention is lacking (Continuation of item 3 of first sheet)**

This International Searching Authority found multiple inventions in this international application, as follows:

      The inventions of claims 1 to 3 relate to an organic fiber-containing electroconductive material.
      The invention of claim 4 relates to a process for producing a nonwoven fabric.
      The invention of claim 5 relates to an electroconductive metal material.
      The invention of claim 6 relates to a method for metallization.
      The inventions of claims 7 to 13 relate to an electroconductive material comprising a lamination integrated composite sheet of a nonwoven fabric and an organic fiber structure sheet, the lamination integrated composite sheet having been metallized.
                  (continued to extra sheet)

1. ☐ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☒ No required additional search fees were timely paid by the applicant. Consequently, this international search report is restricted to the invention first mentioned in the claims; it is covered by claims Nos.:
      An international search report was prepared for the inventions of claims 1 to 3.

**Remark on Protest**
the

☐ The additional search fees were accompanied by the applicant's protest and, where applicable, payment of a protest fee..

☐ The additional search fees were accompanied by the applicant's protest but the applicable protest fee was not paid within the time limit specified in the invitation.

Form PCT/ISA/210 (continuation of first sheet (2)) (April 2005)

**INTERNATIONAL SEARCH REPORT**

International application No.

PCT/JP2007/051025

Continuation of Box No.III of continuation of first sheet(2)

The invention of claim 14 relates to the protection with a resin.
The invention of claim 15 relates to working of an electroconductive gasket.

Form PCT/ISA/210 (extra sheet) (April 2005)

**EP 1 978 798 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4857668 A
- JP 3306665 B
- JP 7166467 A